## Europäisches Patentamt
## European Patent Office
## Office européen des brevets

(11) Publication number: **0 151 019**
**B1**

(12) **EUROPEAN PATENT SPECIFICATION**

(45) Date of publication of patent specification: **02.11.89**

(51) Int. Cl.⁴: **H 01 L 29/74,** H 01 L 29/52, H 01 L 29/08

(21) Application number: **85300576.7**

(22) Date of filing: **29.01.85**

(54) Gate turn-off thryistor.

(30) Priority: **31.01.84 GB 8402459**

(43) Date of publication of application:
**07.08.85 Bulletin 85/32**

(45) Publication of the grant of the patent:
**02.11.89 Bulletin 89/44**

(84) Designated Contracting States:
**DE FR IT**

(56) References cited:
**EP-A-0 022 355**
**EP-A-0 032 264**
**US-A-4 356 503**

(73) Proprietor: **WESTINGHOUSE BRAKE AND SIGNAL HOLDINGS LIMITED**
**Pew Hill**
**Chippenham Wiltshire (GB)**

(72) Inventor: **Anderson, Thomas Alexander**
**21 Ridings Mead**
**Chippenham Wiltshire (GB)**

(74) Representative: **Bird, Vivian John et al**
**PAGE & CO. Temple Gate House**
**Temple Gate Bristol, BS1 6PL (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to gate turn-off thyristors, by which is meant a certain type of Silicon Controlled Rectifier in which main-terminal current may be interrupted by application of a reverse bias voltage to the gate, this voltage being the reverse of that required to turn-on the device and is normally a negative gate to cathode voltage.

The basic structure of a gate turn-off thyristor involves the same four layer, three junction regenerative two transistor module as a conventional Silicon Controlled Rectifier. However, in order to achieve the gate turn-off capability the high regenerative gain is reduced so that the gate is able to divert sufficient charge carriers away from the cathode upon application of negative gate-to-cathode bias to produce turn-off. In terms of the two transistor model of the thyristor the gain of the pnp part is reduced to as low a level as practicable. A preferred method of achieving this is by selectively shorting parts of the anode emitter junction which also more evenly distributes charge carriers across the device but at the expense of the reverse blocking capability. This is not necessarily a disadvantage since gate turn-off thyristors are not normally used in circuit configurations calling for a reverse block capability.

The turn-on performance is improved when the edge length of the cathode emitter is maximised, and the cathode region, in practice, normally consists of an array of cathode elements. If such a cathode array is incorporated in a thyristor having anode shorts the effect on the thyristor characteristics of their mutual interaction is dependent upon their relative dispositions, particularly relative angular orientation, so that the operation characteristics of the device are difficult to predict and reproduce accurately unless the relative alignment can be very closely controlled.

One solution to this problem is to employ column or island shorts in the anode which is satisfactory only so long as the inter-short spacing is small compared to the width of a cathode element, and the short cross-sections have correspondingly small diameters. Both these requirements can be difficult to achieve in practice.

The present invention seeks to avoid these problems by proposing a device configuration which obviates the sensitivity to relative angular alignment of array patterns in the anode and cathode.

According to the present invention there is provided a gate turn-off thyristor including in combination an anode shorting array comprising a plurality of concentric polygonal shorting formations and a cathode region comprising a plurality of arrays of cathode elements, each array including a set of substantially linear elements arranged parallel to a radius and bounded by a sector of a circle the centre of which is co-incident with the centre of the anode shorting array.

Preferably the concentric shorting formations are circular and each sector of the cathode region has an included angle no greater than sixty degrees.

In one form of the invention the elements of each sector array consist of parallel rectilinear strips which subtend an angle with respect to a radius from the common centre no greater than approximately thirty degrees.

The invention and how it may be carried out in practice will now be described, by way of example only, with reference to the accompanying drawings, in which:

Figure 1 shows a plan view of a part of a gate turn-off thyristor including one sector of a cathode array, and

Figure 2 shows a view of the device along the section X—X in Figure 1.

A gate turn-off thyristor employs the same basic four-layer, three-junction structure of superimposed semi-conductor layers of alternating conductivity type as found in conventional Silicon Controlled Rectifiers. These devices also exhibit a similar turn-on capability when a voltage pulse is applied to the gate terminal which forward biases the gate-cathode junction. However, gate turn-off devices differ from conventional thyristors in that they are designed also to turn-off with the application of a reverse bias to the same gate electrode. In order to achieve this capability in practice it is necessary, in terms of the two transistor model of a thyristor to reduce the gain of the pnp component to a suitable low value whilst maintaining the gain of the npn as high as possible. A favoured method achieving this in practice is by the use of anode shorts.

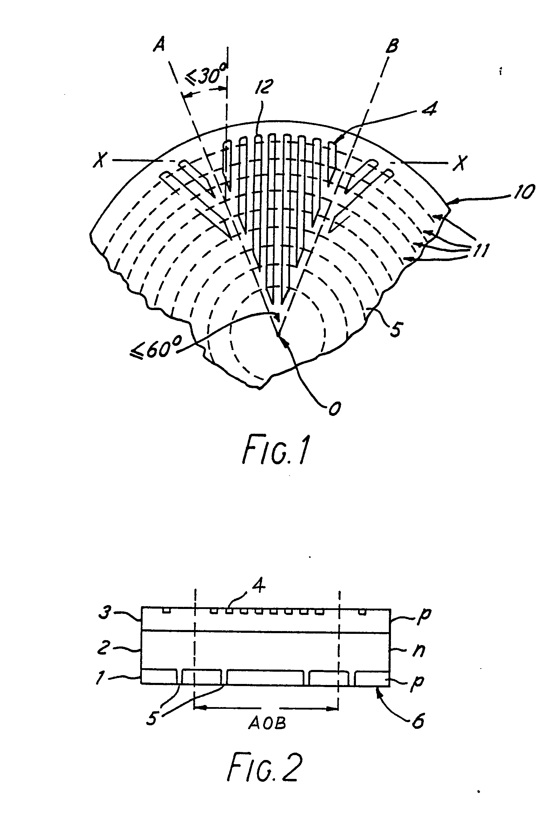

The basic structure of such a gate turn-off thyristor is shown in the cross section in Figure 2 which shows the p-type anode region at 1, the n-type base layer at 2, the p-type gate layer at 3 and an array of the emitter region is generally indicated at reference 4. The anode shorting structure, referred to above comprises concentric annular regions 5 of n-type base material which extend from layer 1 to the surface 6 of the anode end layer.

Referring now to Figure 1 the thyristor device, indicating generally at 10, is circular in plan about a centre 0, and the anode shorts 5 consist of a set of concentric circular formations 11 also based on the common centre 0.

The array of elements forming the cathode region 4 consists of sets of parallel rectilinear elements, of which 12 is one, which extend generally in radial-like manner within a sector defined by dotted lines AO and BO which subtend an included angle at the centre which is preferably no greater than 60 degrees.

Each rectilinear strip 12 in cathode array subtends the same angle to a radius OA or OB which shall be no more than 30 degrees. Therefore the angle at which a cathode element crosses-over the path of an anode short is limited to a narrow range lying 30 degrees either side of a right angle. In the described example the included angle of 60 degrees for each sector of the cathode array gives rise to six identical sectors covering the whole cathode end layer of the device. Thus the relative angular orientation of the anode and cathode patterns is no longer of the importance and the only critical alignment is that of the pattern centres, which may be easily aligned by reference to a diameter of the basic circular silicon slice.

Inspection of the anode shorting arrangement of concentric circles is also simplified, e.g. to identify discontinuities, because of the relatively more simple task when compared to, say, locating missing elements of an array of discrete dots or islands in the case when the shorts have a column configuration.

In conventional thyristors, i.e. other than gate turn-off types, there is normally a unitary cathode emitter which is turned-on along a limited gated edge length, typically an internal circumference of a centrally located region, although much more complex arrangements have been devised for devices for specific applications. Any emitter short, whether in the anode emitter or cathode emitter has the effect of restricting turn-on in its immediate vicinity. Therefore a linear short which sub-divides an emitter into separate sub-regions tends strongly to prevent the spread of conduction across that line. In the described embodiment of the drawings the concentric annular shorts are effective to limit the spread of conduction to the annular bands where the corresponding cathode emitter receives a gate turn-on signal. In a conventional thyristor the majority of the device would not satisfactorily switch into conduction.

In contrast, in a gate turn-off thyristor of the type described the cathode emitter consists of a multiplicity of a strip-like regions which are operated electrically in parallel and each is gated-on along the whole length of its major edges. Preferably, after the manner of a transistor, the gate signal is maintained for the duration of forward conduction. Therefore, for a device to reach a fully turned-on state a conduction region is required to spread no more than half the width of an emitter strip. In practice, this is almost indistinguishable from the turn-on area arising directly from an applied gate signal, and conduction is never required to spontaneously cross the line of an anode emitter short.

In an alternative construction the concentric annular regions 5 of the anode array (see Figures 1 and 2) are discontinuous rings and include at least one and preferably several narrow breaks or gaps in their circumferences. If these gaps are too wide the dynamic characteristics of the device become dependent upon the relative angular orientation of the cathode and anode arrays. To avoid this it is preferred to limit the size of the gaps to no greater than half the width of a cathode emitter strip, i.e. of one of the linear elements in the array comprising the cathode.

## Claims

1. A gate turn-off thyristor including in combination an anode shorting array (11) comprising a plurality of concentric polygonal shorting formations (5) and a cathode region comprising a plurality of arrays (4) of cathode elements (12), each array (4) including a set of substantially linear elements (12) arranged parallel to a radius and bounded by a sector (AOB) of a circle the centre (0) of which is co-incident with the centre of the anode shorting array (11).

2. A gate turn-off thyristor according to Claim 1 wherein each sector (AOB) of the cathode region (4) has an included angle no greater than sixty degrees.

3. A gate turn-off thyristor according to Claim 1 or Claim 2 wherein the elements of each sector array (4) consist of parallel rectilinear strips (12) which subtend an angle with respect to a radius from the common centre no greater than approximately thirty degrees.

4. A gate turn-off thyristor according to any preceding claim wherein the concentric shorting formations (5) of the anode shorting array (11) are circular.

5. A gate turn-off thyristor according to any preceding claim wherein the concentric polygonal shorting formations (5) of the anode shorting array (11) include at least one discontinuity.

6. A gate turn-off thyristor according to claim 5 wherein said discontinuity is provided by a gap having a width no greater than half the width of an element (12) of the cathode array (4).

## Patentansprüche

1. Gate-abschaltbarer Thyristor, in Kombination aufweisend einen Anodenkurzschlußbereich (11), der eine Mehrzahl konzentrischer vieleckiger Kurzschluß-Formationen (5) umfaßt und einen Kathodenbereich, der eine Mehrzahl von Bereichen (4) von Kathodenelementen (12) aufweist, wobei jeder Bereich (4) einen Satz von im wesentlichen linearen Elementen (12) aufweist, die parallel zu einem Radius und durch einen Sektor (AOB) eines Kreises mit dem Zentrum (0) umgrenzt sind, welches mit dem Zentrum des Anoden-Kurzschlußbereichs (11) zusammenfällt.

2. Gate-abschaltbarer Thyristor nach Anspruch 1, dadurch gekennzeichnet, daß jeder Sektor (AOB) des Kathodenbereiches (4) einen eingeschlossenen Winkel von nicht größer als 60° aufweist.

3. Gate-abschaltbarer Thyristor nach einem der Ansprüche 1 oder 2, dadurch gekennzeichnet, daß die Elemente jedes Sektorbereiches (4) aus parallelen gradlinigen Streifen (12) bestehen, welche sich in bezug auf einen Radius von dem gemeinsamen Zentrum in einem Winkel von nicht größer als etwa 30° erstrecken.

4. Gate-abschaltbarer Thyristor nach einem der vorangehenden Ansprüche, dadurch gekennzeichnet, daß die konzentrischen Kurzschlußformationen (5) des Anoden-Kurzschlußbereiches (11) kreisförmig sind.

5. Gate-abschaltbarer Thyristor nach einem der vorangehenden Ansprüche, dadurch gekennzeichnet, daß die konzentrischen polygonalen Kurzschlußformationen (5) des Anoden-Kurzschlußbereichs (11) wenigstens eine Diskontinuität aufweisen.

6. Gate-abschaltbarer Thyristor nach Anspruch 5, dadurch gekennzeichnet, daß die Diskontinuität durch einen Zwischenraum geschaffen ist, der eine Erstreckung von nicht mehr als der Hälfte der Breite eines Elementes (12) des Kathodenbereiches (4) hat.

**Revendications**

1. Thyristor à blocage par la gâchette caractérisé en ce qu'il comporte en combinaison une disposition anodique de court-circuit (11) comprenant une pluralité de ponts (5) polygonaux concentriques et une région cathodique comprenant une pluralité d'agencements (4) d'éléments cathodiques (12), chaque agencement (4) comprenant une suite d'éléments (12) sensiblement linéaires disposés parallèlement à un rayon et inclus dans un secteur circulaire AOB de centre 0 coïncidant avec le centre de la disposition anodique de court-circuit (11).

2. Thyristor à blocage par la gâchette selon la revendication 1, caractérisé en ce que chaque secteur AOB de la région cathodique (4) a un angle au sommet inférieur à 60°.

3. Thyristor à blocage par la gâchette selon la revendication 1 ou 2, caractérisé en ce que les éléments de chaque secteur de l'agencement (4) consistent essentiellement en des bandes rectilignes parallèles (12) formant par rapport à un rayon partant du centre commun, un angle inférieur que sensiblement 30°.

4. Thyristor à commande par la gâchette selon l'une des revendications précédentes, caractérisé en ce que les ponts concentriques (5) de la disposition anodique de court-circuit (11) sont circulaires.

5. Thyristor à commande par la gâchette selon l'une des revendications précédentes, caractérisé en ce que les ponts concentriques polygonaux de la disposition anodique de court-circuit (11) comprennent au moins une discontinuité.

6. Thyristor à commande par la gâchette selon la revendication 5, caractérisé en ce que ladite discontinuité est faite par un espacement ayant une largeur inférieure à la moitié de la largeur d'un élément (12) de l'arrangement cathodique (4).

*FIG.1*

*FIG.2*

1